# EUROPÄISCHE PATENTSCHRIFT

(11) **EP 3 403 107 B1**
(45) Veröffentlichungstag und Bekanntmachung des Hinweises auf die Patenterteilung: **01.06.2022**
(21) Anmeldenummer: 17700414.0
(22) Anmeldetag: 13.01.2017
(51) Int. Cl.: G01R 31/52

(54) **VERFAHREN UND VORRICHTUNG ZUR KURZSCHLUSSUEBERWACHUNG EINER DREHSTROMLAST**
METHOD AND DEVICE FOR SHORT-CIRCUIT MONITORING OF A THREE-PHASE LOAD
PROCÉDÉ ET DISPOSITIF DE SURVEILLANCE D'UN COURT-CIRCUIT D'UNE CHARGE TRIPHASÉE

(30) Priorität: 15.01.2016 DE 102016100671
(43) Veröffentlichungstag der Anmeldung: 21.11.2018
(73) Patentinhaber: Phoenix Contact GmbH & Co. KG, 32825 Blomberg (DE)
(72) Erfinder: SCHAPER, Elmar, 32676 Lügde (DE); HAWEL, Daniel, 32756 Detmold (DE); SCHUERGENS, Detlev, 32825 Blomberg (DE)
(74) Vertreter: Blumbach · Zinngrebe Patentanwälte PartG mbB
(86) Internationale Anmeldenummer: PCT/EP2017/050658
(87) Internationale Veröffentlichungsnummer: WO 2017/121846

(56) Entgegenhaltungen:
- DE-A1- 4 142 471
- DE-A1- 19 954 950
- DE-A1-102014 106 130

## Beschreibung

Die Erfindung betrifft allgemein Drehstromsysteme und insbesondere eine Vorrichtung und ein Verfahren zur Kurzschlussüberwachung einer Drehstromlast.

In Drehstromsystemen, auch Dreiphasenwechselstromsysteme genannt, ist eine Kurzschlussüberwachung für eine an dem Drehstromsystem betriebene Drehstromlast, wie beispielsweise ein Motor, ein Heizelement oder eine Lampe, aus Gründen der elektrischen Sicherheit erforderlich.

Zu diesem Zweck erfolgt in der Regel mittels Stromsensoren eine Überwachung der Stromstärke in den Strompfaden, über welche die Drehstromlast an die Leiter des Drehstromnetzes angeschlossen ist, wobei sich ein Kurzschluss an der Drehstromlast durch sprunghafte Änderungen der gemessenen Stromstärke bemerkbar macht.

Wechselstromsensoren, auch als Stromwandler bezeichnet, bestehen meist aus einem Ringkern und sind wie ein Transformator ausgeführt. Das magnetische Wechselfeld eines vom zu erfassenden Wechselstrom durchflossenen Leiters induziert in der Messspule einen Wechselstrom, welcher über das reziproke Windungszahlverhältnis proportional zum Messstrom ist.

Stromsensoren in Drehstromanwendungen liefern somit ein proportionales Abbild des Eingangssignals, wobei das Wirkprinzip des Wandlers beispielsweise auf einer Rogowskispule, einem Hallsensor oder einem Transformator basiert. Bekannt sind beispielsweise auch für Wechselströme ausgelegte Stromzangen mit großer Öffnung, die über den zu messenden Stromleiter geklappt werden können.

Durch Wahl des Windungszahlverhältnisses der beteiligten Spulen kann ein großer Messbereich abgedeckt werden, ohne den primären Stromkreis nennenswert zu beeinflussen. Stromwandler nach diesem Prinzip benötigen in der Regel keine externe Energie zum Betrieb.

Für eine Kurzschlussüberwachung mit Stromsensoren in Drehstromanwendungen werden in der Regel zunächst die Stromdaten als Analogwerte erfasst. Der Signalverlauf der erfassten Stromdaten wird beispielsweise von einer Einrichtung zur Motorstromüberwachung auf mögliche sprungartige Veränderungen geprüft, die auf einen Kurzschluss hindeuten.

Aus DE 10 2011 001340 A1 ist beispielsweise eine elektrische Vorrichtung für den Kurzschlussschutz einer Drehstromlast in einem Drehstromsystem bekannt, bei welcher ein Mittel zum Erkennen eines Kurzschlusses an der Drehstromlast vorgesehen ist, wobei das Mittel zum Erkennen eines Kurzschlusses einen Stromsensor aufweist, sowie ein Mittel zum Erkennen einer Schaltschwelle, welches derart ausgestaltet ist, dass bei Überschreiten einer vordefinierten Schaltschwelle ein Kurzschluss erkannt wird.

Durch elektrische und/oder elektromagnetische Störungen kann das Ausgangssignal der Sensoren beeinflusst werden. Gerade Stromsensoren, die für Kurzschlussströme dimensioniert sind, haben aufgrund der hohen Anstiegsgeschwindigkeiten beim Nutzsignal die Eigenschaft, ein Signal zu liefern, das einer Störung gleicht.

Durch Schalthandlungen im Drehstromsystem kann das Ausgangssignal der Stromsensoren durch magnetische oder elektrische Einkopplung gestört werden. Eine Vorrichtung zur Kurzschlussüberwachung wird typischerweise zum Beispiel mit einer Betriebsspannung von 24 V betrieben, während die Spannung zwischen zwei Leitern des Drehstromnetzes etwa 400 V beträgt. Diese Spannungsunterschiede, aber auch die Koppelkapazität der Leitungen und parallele Führungen der Leitungen, spielen für die Kopplung eine entscheidende Rolle. Der für die Störgröße ursächliche Störstrom wird meist über Leitungen an das Gerät herangeführt und dringt über die Geräteschnittstellen ein. Über parasitäre Gehäusekapazitäten kann der Störstrom ebenso fließen, wie über Kabelschirmkapazitäten. Sehr leicht gelangt er über galvanische Verbindungen ins Geräteinnere. Ausreichend sind wenige Pikofarad parasitäre Koppelkapazität galvanisch trennender Schnittstellen.

Aus DE 43 29 919 A1 ist ein Verfahren und eine Vorrichtung zum Betreiben eines Verbrauchers in einem Fahrzeug bekannt, wobei die Vorrichtung Schaltelemente umfasst, und wobei der Strom durch jedes Schaltelement erfasst und jeweils einzeln auf das Erreichen bzw. Überschreiten eines vorgegebenen Maximalwertes überwacht wird. Würde bei jedem solchen Überschreiten ein Kurzschluss im Bereich des Verbrauchers angenommen und eine Abschaltung bewirkt, so würde auch bei einer Störung, beispielsweise durch Störstrahlung verursacht, eine Abschaltung erfolgen. Damit kurzzeitige Störungen nicht zur Abschaltung der Vorrichtung führen, wird mit Überschreiten des Maximalstroms ein Zeitglied gestartet und erst dann ein Fehler erkannt, wenn diese Überschreitung eine vorgegebene Zeit lang andauert. Nachteilig an dem in DE 43 29 919 A1 beschriebenen Verfahren ist, dass das Erkennen eines Kurzschlusses zeitverzögert erfolgt und eine Fehlerkennung nur bei kurzzeitigen Störungen vermieden werden kann.

Weitere Vorrichtungen und Verfahren zur Kurzschlussüberwachung werden in DE 199 54 950 A1, DE 10 2014 106130 A1 und DE 41 42 471 A1 offenbart.

Der vorliegenden Erfindung liegt daher die Aufgabe zu Grunde, einen Weg aufzuzeigen, wie eine Kurzschlussüberwachung einer Drehstromlast verbessert werden kann.

Diese Aufgabe wird durch die Merkmale der unabhängigen Ansprüche gelöst. Vorteilhafte Ausführungsformen sind Gegenstand der abhängigen Ansprüche.

Dementsprechend umfasst eine Vorrichtung zur Kurzschlussüberwachung einer an ein Drehstromnetz angeschlossenen Drehstromlast wenigstens einen im Strompfad einer Phase des Drehstromnetzes angeordneten Stromsensor, eine Verarbeitungseinheit zum Auswerten der Messwerte des wenigstens einen Stromsensors mit jeweils einem Anschluss für jeden Stromsensor, an den der jeweilige Stromsensor über eine Anschlussleitung angeschlossen ist, wobei die Verarbeitungseinheit dazu ausgebildet ist, durch Auswertung der von dem Stromsensor ermittelten Messwerte einen Kurzschluss an der Drehstromlast zu erkennen, und wobei die Auswertung eine Plausibilitätsprüfung der ermittelten Messwerte umfasst, um zwischen einem Kurzschluss und einer Beeinflussung der ermittelten Messwerte durch eine elektrische und/oder elektromagnetische Störung zu unterscheiden.

Zur Kurzschlussüberwachung wird der Strom im Strompfad mehrerer oder aller Phasen des Drehstromnetzes gemessen. Dementsprechend umfasst die Vorrichtung mehrere, insbesondere drei, Stromsensoren, die jeweils im Strompfad unterschiedlicher Phasen des Drehstromnetzes angeordnet sind und jeweils über Anschlussleitungen an zugeordnete Anschlüsse der Verarbeitungseinheit angeschlossen sind. Mit anderen Worten ist in dieser Ausführungsform besonders vorteilhaft in jedem Strompfad jeweils ein Stromsensor der Vorrichtung zur Kurzschlussüberwachung angeordnet.

Es ist weiterhin vorgesehen, dass wenigstens zwei der Anschlussleitungen, über welche die Stromsensoren an die Verarbeitungseinheit angeschlossen sind, miteinander über ein Koppelglied verbunden sind. Besonders vorteilhaft sind alle Anschlussleitungen, über welche die Stromsensoren an die Verarbeitungseinheit angeschlossen sind, jeweils paarweise miteinander über separate Koppelglieder miteinander verbunden.

Die Koppelglieder bewirken insbesondere eine kapazitive Kopplung zwischen den Anschlussleitungen und umfassen dementsprechend vorteilhaft jeweils wenigstens einen Kondensator.

Die Koppelglieder dienen insbesondere dazu, dass elektrische und/oder elektromagnetische Störungen, welche in die Vorrichtung zur Kurzschlussüberwachung eingekoppelt werden, gleichmäßig auf die Anschlussleitungen verteilt werden, um so das durch eine Störung verursachte Spannungsniveau an allen Anschlüssen der Verarbeitungseinheit, an denen Stromsensoren angeschlossen sind, gleich zu halten, unabhängig davon, aus welcher Richtung und an welcher Anschlussleitung die Störung eingekoppelt wird.

Die Nutzsignale der Stromsensoren, d.h. die Messsignale der Strommessung hingegen sollen durch die Koppelglieder nicht beeinflusst werden. Die Koppelglieder sind daher besonders vorteilhaft jeweils derart als Hochpass ausgebildet, dass die Anschlussleitungen für hochfrequente Signale im Wesentlichen kurzgeschlossen werden, auf den Anschlussleitungen übertragene Messsignale der Stromsensoren durch die Koppelglieder aber im Wesentlichen unbeeinflusst werden. Insbesondere werden die Koppelglieder derart abgestimmt, dass Nutzsignale mit einer Frequenz von 50 Hz nicht beeinflusst werden.

Zur Kurzschlussüberwachung ist die Vorrichtung vorzugsweise dazu ausgebildet, Strommesswerte mittels der Stromsensoren kontinuierlich oder in vorgegebenen Zeitabständen, insbesondere zyklisch, zu ermitteln. Die Auswertung der von den Stromsensoren ermittelten Messwerte durch die Verarbeitungseinheit umfasst vorteilhaft eine Auswertung des zeitlichen Verlaufs der ermittelten Messwerte, um insbesondere sprunghafte Veränderungen im Signalverlauf zu erkennen.

Vorzugsweise ist die Verarbeitungseinheit dazu ausgebildet, einen Kurzschluss zu erkennen, wenn wenigstens ein ermittelter Stromwert oder ein aus mehreren ermittelten Stromwerten abgeleiteter Wert eine vorgegebene Schwelle überschreitet und die ermittelten Stromwerte vorgegebene Plausibilitätsregeln einhalten.

In einer vorteilhaften Ausführungsform ist die Verarbeitungseinheit dazu ausgebildet, als abgeleitete Werte die maximalen Amplituden der positiven und negativen Halbwellen des Stromverlaufs während einer vorgegebenen Messdauer zu ermitteln.

Es sei angemerkt, dass die Verarbeitungseinheit dazu ausgebildet sein kann, die von den Stromsensoren erfassten analogen Messsignale direkt mittels einer entsprechenden analogen Schaltungsanordnung analog zu verarbeiten oder die Messsignale in digitale Daten umzuwandeln und beispielsweise mittels eines Mikrocontrollers auszuwerten.

Ein Kerngedanke der Erfindung besteht darin, bei der Auswertung der erfassten Messsignale der Stromsensoren eine Plausibilitätsprüfung der ermittelten Messwerte durchzuführen, um zwischen einem Kurzschluss und einer Beeinflussung der ermittelten Messwerte durch eine elektrische und/oder elektromagnetische Störung zu unterscheiden.

In einer vorteilhaften Ausführungsform ist als eine einzuhaltende Plausibilitätsregel beispielsweise vorgesehen, dass die von den Stromsensoren ermittelten Stromwerte zu einem gegebenen Zeitpunkt nicht alle das gleiche Vorzeichen aufweisen. Je nach eingesetzter Drehstromlast und zu erwartender Störungen können weitere geeignete Plausibilitätsregeln definiert werden.

Vorzugsweise umfasst die Vorrichtung einen Steuerausgang zum Bereitstellen eines Steuersignals bei Erkennen eines Kurzschlusses durch die Verarbeitungseinheit, um bei Erkennen eines Kurzschlusses geeignete Maßnahmen einzuleiten, wie beispielsweise eine sichere Abschaltung der Drehstromlast zu bewirken.

Die Aufgabe wird auch durch ein Verfahren zur Kurzschlussüberwachung einer an ein Drehstromnetz angeschlossenen Drehstromlast gelöst, welches vorsieht, mittels wenigstens eines im Strompfad einer Phase des Drehstromnetzes angeordneten Stromsensors Messwerte zu ermitteln und die ermittelten Messwerte oder daraus abgeleitete Werte durch eine Verarbeitungseinheit auszuwerten, um einen Kurzschluss zu erkennen, wobei das Auswerten eine Plausibilitätsprüfung der ermittelten Messwerte umfasst, um zwischen einem Kurzschluss und einer Beeinflussung der ermittelten Messwerte durch eine elektrische und/oder elektromagnetische Störung zu unterscheiden.

Das Verfahren sieht vorteilhafte Ausführungsformen analog zu den oben beschriebenen vorteilhaften Ausführungsformen der Vorrichtung vor.

Dementsprechend sieht das Verfahren vor, dass das Ermitteln der Messwerte mittels mehrerer, insbesondere dreier, Stromsensoren, die jeweils im Strompfad unterschiedlicher Phasen des Drehstromnetzes angeordnet sind und jeweils über Anschlussleitungen an zugeordnete Anschlüsse der Verarbeitungseinheit angeschlossen sind, erfolgt, wobei insbesondere wenigstens zwei der Anschlussleitungen, über welche die Stromsensoren an die Verarbeitungseinheit angeschlossen sind, miteinander über ein Koppelglied verbunden sind , und wobei besonders vorteilhaft alle Anschlussleitungen, über welche die Stromsensoren an die Verarbeitungseinheit angeschlossen sind, jeweils paarweise miteinander über separate Koppelglieder miteinander verbunden sind.

Das Ermitteln der Messwerte erfolgt vorzugsweise kontinuierlich oder in vorgegebenen Zeitabständen, insbesondere zyklisch, wobei das Auswerten durch die Verarbeitungseinheit vorzugsweise eine Auswertung des zeitlichen Verlaufs der ermittelten Messwerte umfasst.

Durch die Verarbeitungseinheit wird insbesondere dann ein Kurzschluss erkannt, wenn wenigstens ein ermittelter Stromwert oder ein aus mehreren ermittelten Stromwerten abgeleiteter Wert eine vorgegebene Schwelle überschreitet und die ermittelten Stromwerte vorgegebene Plausibilitätsregeln einhalten, wobei eine einzuhaltende Plausibilitätsregel beispielsweise vorsieht, dass die von den Stromsensoren ermittelten Stromwerte zu einem gegebenen Zeitpunkt nicht alle das gleiche Vorzeichen aufweisen.

Ferner sieht das Verfahren vorteilhaft vor, dass bei Erkennen eines Kurzschlusses durch die Verarbeitungseinheit ein Steuersignal erzeugt wird. Vorteilhaft sieht das Verfahren vor, dass mittels des Steuersignals eine Aktion bewirkt wird, beispielsweise die Anzeige einer Fehlerinformation, die Weiterleitung einer Fehlermeldung oder ein sicheres Abschalten der Drehstromlast.

Die Erfindung wird nachfolgend anhand einiger Ausführungsbeispiele in Verbindung mit den Zeichnungen näher erläutert. Gleiche Bezugszeichen bezeichnen dabei gleiche oder ähnliche Komponenten. Es zeigen:
- Fig. 1: schematisch eine bevorzugte Ausführungsform einer erfindungsgemäßen Vorrichtung zur Kurzschlussüberwachung einer Drehstromlast,
- Fig. 2: schematisch die Schritte einer bevorzugten Ausführungsform eines erfindungsgemäßen Verfahrens zur Kurzschlussüberwachung einer Drehstromlast.

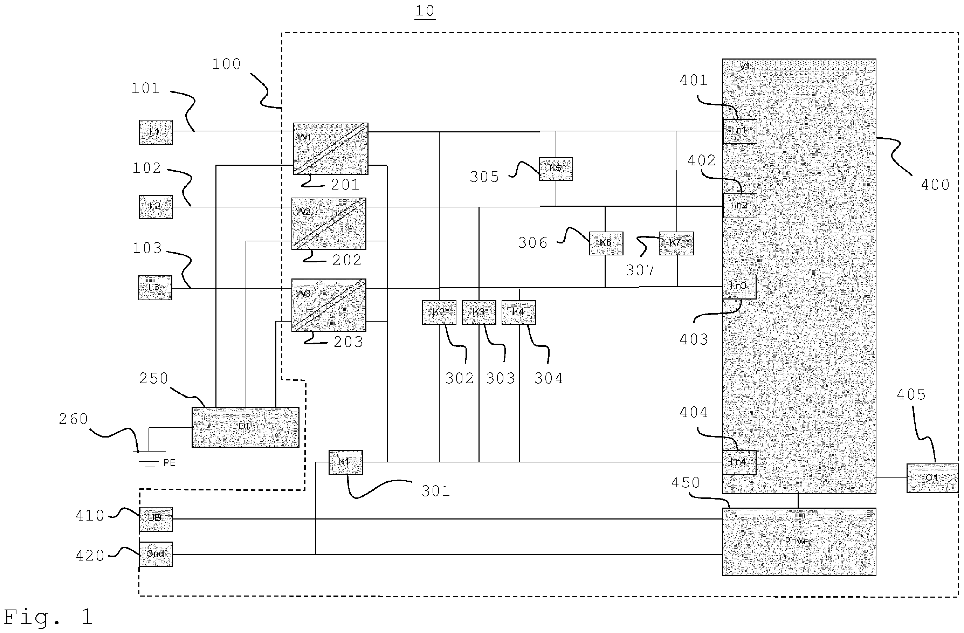

Fig. 1 zeigt ein Drehstromsystem 10, in welchem eine Drehstromlast 250 über Strompfade 101, 102 und 103 an die Leiter eines in Fig. 1 nicht dargestellten Drehstromnetzes angeschlossen ist, wobei durch die Strompfade jeweils ein Strom fließt, was durch die in Fig. 1 angegebenen Bezeichnungen I1, I2 bzw. I3 angedeutet wird.

Die Drehstromlast 250 kann beispielsweise in Stern- oder Dreiecksschaltung betrieben werden. Im dargestellten Ausführungsbeispiel wird die Drehstromlast 250 in Sternschaltung betrieben, wobei die Sternbrücke auf N Potenzial liegt und mit dem Schutzleiter 260 verbunden ist.

Es ist eine Vorrichtung 100 zur Kurzschlussüberwachung der an das Drehstromnetz angeschlossenen Drehstromlast 250 vorgesehen, welche drei im Strompfad der Phase des Drehstromnetzes angeordnete Stromsensoren 201,202 und 203 umfasst, sowie eine Verarbeitungseinheit 400 zum Auswerten der Messwerte der Stromsensoren 201, 202 und 203 mit jeweils einem Anschluss 401, 402 bzw. 403 für jeden der Stromsensoren, an den der jeweilige Stromsensor über eine Anschlussleitung angeschlossen ist. Ferner ist für die Stromsensoren ein gemeinsamer Referenz-Anschluss 404 der Verarbeitungseinheit 400 vorgesehen. Die zwischen einem der Anschlüsse 401, 402 bzw. 403 und dem Referenz-Anschluss 404 anliegende Spannung ist proportional zu der von dem jeweiligen Stromsensor 201 202 bzw. 203 gemessenen Stromstärke. Die Stromsensoren 201-203 sind insbesondere als Stromwandler ausgebildet. Es kann aber prinzipiell jede bekannte oder auch zukünftige Art eines geeigneten Stromsensors eingesetzt werden.

Die Anschlussleitungen, über welche die Stromsensoren 201, 202 bzw. 203 an die Anschlüsse 401, 402 bzw. 403 angeschlossen sind, sind jeweils paarweise über Koppelglieder 305, 306 und 307 miteinander verbunden. Im dargestellten Ausführungsbeispiel sind ferner die Anschlussleitungen, über welche die Stromsensoren 201, 202 bzw. 203 an die Anschlüsse 401, 402 bzw. 403 angeschlossen sind, jeweils mit der Anschlussleitung, über welche die Stromsensoren 201, 202 bzw. 203 an den Referenz-Anschluss 404 angeschlossen sind, über Koppelglieder 302, 303 bzw. 304 verbunden.

Die Vorrichtung 100 umfasst ferner Anschlüsse 410 und 420 zum Anschließen der Vorrichtung 100 an eine Versorgungsspannung, wobei diese im dargestellten Ausführungsbeispiel mit einem Netzteil 450 verbunden sind, über das die Verarbeitungseinheit 400 mit elektrischer Energie versorgt wird, und wobei der Anschluss 420 als Masseanschluss ausgebildet ist.

Im dargestellten Ausführungsbeispiel ist ferner die Anschlussleitung, über welche die Stromsensoren 201, 202 bzw. 203 an den Referenz-Anschluss 404 angeschlossen sind, über ein weiteres Koppelglied mit dem Masseanschluss 420 verbunden.

Die Koppelglieder 301-307 bewirken insbesondere eine kapazitive Kopplung zwischen den Anschlussleitungen und umfassen dementsprechend vorteilhaft jeweils wenigstens einen Kondensator. Die Koppelglieder 301-307 dienen insbesondere dazu, dass elektrische und/oder elektromagnetische Störungen, welche in die Vorrichtung 100 eingekoppelt werden, gleichmäßig auf die Anschlussleitungen verteilt werden, um so das durch eine Störung verursachte Spannungsniveau an allen Anschlüssen 401-404 der Verarbeitungseinheit, an denen die Stromsensoren 201-203 angeschlossen sind, gleich zu halten, unabhängig davon, aus welcher Richtung und an welcher Anschlussleitung die Störung eingekoppelt wird.

Die Verarbeitungseinheit 400 ist dazu ausgebildet, durch Auswertung der von den Stromsensoren 201, 202 und 203 ermittelten Messwerte einen Kurzschluss an der Drehstromlast zu erkennen, wobei die Auswertung eine Plausibilitätsprüfung der ermittelten Messwerte umfasst, um zwischen einem Kurzschluss und einer Beeinflussung der ermittelten Messwerte durch eine elektrische und/oder elektromagnetische Störung zu unterscheiden.

Die Vorrichtung weist ferner einen Steuerausgang 405 zum Bereitstellen eines Steuersignals durch die Verarbeitungseinheit 400 bei Erkennen eines Kurzschlusses auf.

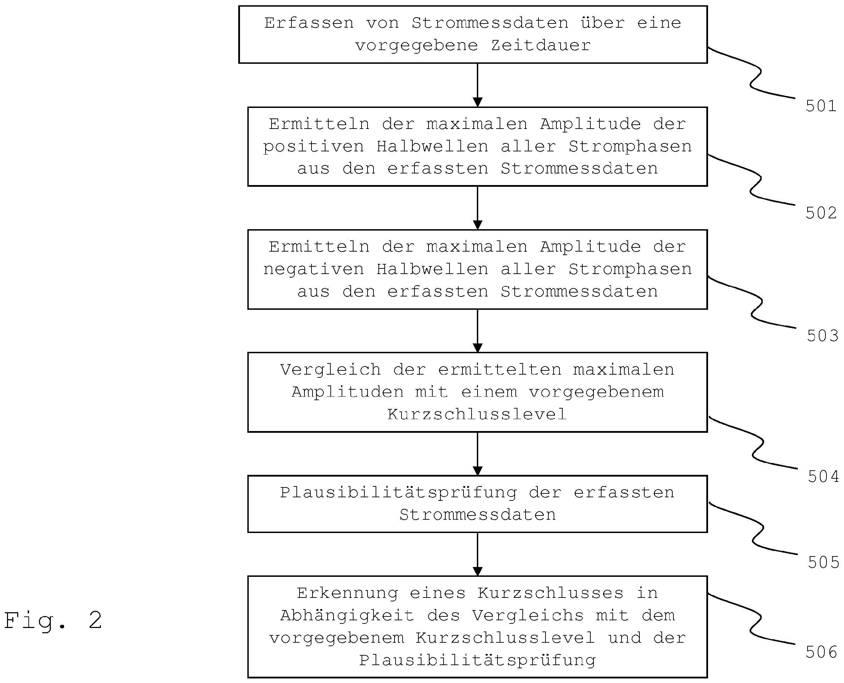

Fig. 2 zeigt schematisch die Schritte einer bevorzugten Ausführungsform eines erfindungsgemäßen Verfahrens zur Kurzschlussüberwachung einer Drehstromlast.

In Schritt 501 werden über eine vorgegebene Zeitdauer mittels der Stromsensoren 201, 202 und 203 Strommessdaten erfasst. Aus den erfassten Strommessdaten werden in Schritt 502 die maximalen Amplituden der positiven Halbwellen aller Stromphasen und in Schritt 503 die maximalen Amplituden der negativen Halbwellen aller Stromphasen ermittelt. In Schritt 504 werden die ermittelten maximalen Amplituden jeweils mit einem vorgegebenen Kurzschlusslevel verglichen und in Schritt 505 wird eine Plausibilitätsprüfung der erfassten Strommessdaten durchgeführt. In Schritt 506 wird dann die Erkennung eines Kurzschlusses in Abhängigkeit des Ergebnisses des Vergleichs der jeweiligen ermittelten maximalen Amplituden mit dem vorgegebenen Kurzschlusslevel und in Abhängigkeit des Ergebnisses der Plausibilitätsprüfung durchgeführt, wobei ein Kurzschluss erkannt wird, wenn eine der ermittelten maximalen Amplituden das Kurzschlusslevel überschreitet und die für die Plausibilitätsprüfung definierten Plausibilitätsregeln eingehalten werden, d.h. zum Beispiel nicht alle Strommesswerte zu einem gegebenen Messzeitpunkt das gleiche Vorzeichen aufweisen, da dies auf ein Überschreiten des Kurschlusslevels nicht aufgrund eines Kurzschlusses, sondern aufgrund einer Störung hindeutet.

Die Erfindung stellt somit ein Messverfahren und ein direkt anzeigendes Messsystem bereit, dass in seinen Messparametern das EMC-Verhalten (EMC: Elektromagnetische Verträglichkeit) des Messobjektes berücksichtigt und dadurch die Störeffekte bzw. die Messsignale möglichst exakt und ohne Rückwirkungen erfasst und im Fehlerfall eine Art "Freund/Feind" Erkennung berücksichtigt.

Aus dem Zeitverlauf der Messwerte ließe sich ohne die Koppelglieder 301-307 erfahrungsgemäß nur schwer die Entscheidung ableiten, ob ein Gerät gestört ist oder nicht.

Die Erfindung sieht vorteilhaft vor, elektrische und/oder elektromagnetische Störungen durch eine Hardware zwischen den Kreisen gezielt zu koppeln, wodurch sich zu jedem Zeitpunkt gleiche störungsbedingte Spannungsverhältnisse an den Anschlüssen 401, 402 und 403 ergeben.

Insbesondere bei steil ansteigenden Nutzsignalen bleibt dem Kurzschlussstromsensor und der Verarbeitung kaum Zeit das Nutzsignal von einer elektrischen und/oder elektromagnetischen Störung zu differenzieren.

Mit der beschriebenen Vorrichtung 100 werden zu hohe, den ordnungsgemäßen Betrieb des Gerätes sowie der Schaltung beeinflussende Störgrößen erkannt und die Weiterverarbeitung und Auslösung einer Überwachungsschwelle über den Steuerausgang 405 oder ein Ansprechen des Systems verhindert.

Die Verarbeitungseinheit 400 prüft die Daten und den Signalverlauf fortwährend auf mögliche sprungartige Veränderungen hinsichtlich eines Kurzschlusses. Ein Kurzschluss liegt insbesondere dann vor, wenn die ermittelte maximale Amplitudenabweichung aus den aktuellen Stromdaten eine vorgegebene Schwelle überschreitet und die Plausibilitätskontrolle ergibt, dass nicht alle Stromdaten in der positiven oder der negativen Halbwelle liegen.

Vorteilhaft wird das Ereignis "Kurzschluss" ausgelöst, wenn in einer aufeinanderfolgenden Serie von Stromdaten bzw. Abtastungen ein Kurzschluss festgestellt wird.

Mit der Plausibilitätskontrolle werden Signale auf einen korrekten zeitlichen Verlauf überprüft. Beispielsweise werden die drei Ströme im Drehstromsystem zu keinem Zeitpunkt proportionale Analogsignale mit dem gleichen Vorzeichenverlauf haben. Durch die Plausibilitätskontrolle werden Nutzsignale eindeutig von elektrischen oder elektromagnetischen Störungen unterschieden.

### Bezugszeichenliste

- 10: Drehstromsystem
- 100: Vorrichtung zur Kurzschlussüberwachung
- 101-103: Strompfade
- 201-203: Stromwandler
- 250: Drehstromlast
- 260: Schutzleiter
- 301-307: Koppelglieder
- 400: Verarbeitungseinheit
- 401-403: Anschlüsse für analoge Strommesssignale
- 404: Anschluss für analoges Referenzsignal
- 405: Ausgang
- 410, 420: Anschlüsse für Versorgungsspannung
- 450: Netzteil
- 501-505: Verfahrensschritte

## Patentansprüche

1. Vorrichtung zur Kurzschlussüberwachung (100) einer an ein Drehstromnetz angeschlossenen Drehstromlast (250), umfassend
- mehrere Stromsensoren (201-203), die jeweils im Strompfad (101-103) unterschiedlicher Phasen des Drehstromnetzes angeordnet sind,
- eine Verarbeitungseinheit (400) zum Auswerten der Messwerte der Stromsensoren (201-203) mit jeweils einem Anschluss (401-404) für jeden Stromsensor (201-203), an den der jeweilige Stromsensor (201-203) über eine Anschlussleitung angeschlossen ist, wobei die Verarbeitungseinheit (400) dazu ausgebildet ist, durch Auswertung der von den Stromsensoren (201-203) ermittelten Messwerte einen Kurzschluss an der Drehstromlast (250) zu erkennen, wobei die Auswertung eine Plausibilitätsprüfung der ermittelten Messwerte umfasst, um zwischen einem Kurzschluss und einer Beeinflussung der ermittelten Messwerte durch eine elektrische und/oder elektromagnetische Störung zu unterscheiden, und wobei wenigstens zwei der Anschlussleitungen, über welche die Stromsensoren (201-203) an die Verarbeitungseinheit (400) angeschlossen sind, miteinander über ein Koppelglied (305-307) verbunden sind.

2. Vorrichtung nach Anspruch 1, umfassend drei Stromsensoren (201-203), die jeweils im Strompfad (101-103) unterschiedlicher Phasen des Drehstromnetzes angeordnet sind und jeweils über Anschlussleitungen an zugeordnete Anschlüsse (401-404) der Verarbeitungseinheit (400) angeschlossen sind.

3. Vorrichtung nach einem der vorstehenden Ansprüche, wobei die Anschlussleitungen, über welche die Stromsensoren (201-203) an die Verarbeitungseinheit (400) angeschlossen sind, jeweils paarweise miteinander über separate Koppelglieder (305-307) miteinander verbunden sind.

4. Vorrichtung nach einem der vorstehenden Ansprüche, wobei die Koppelglieder (305-307) jeweils derart als Hochpass ausgebildet sind, dass die Anschlussleitungen für hochfrequente Signale im Wesentlichen kurzgeschlossen werden, auf den Anschlussleitungen übertragene Messsignale der Stromsensoren (201-203) durch die Koppelglieder (305-307) aber im Wesentlichen unbeeinflusst werden.

5. Vorrichtung nach einem der vorstehenden Ansprüche, dazu ausgebildet, zur Kurzschlussüberwachung kontinuierlich oder in vorgegebenen Zeitabständen, insbesondere zyklisch, Strommesswerte mittels der Stromsensoren (201-203) zu ermitteln.

6. Vorrichtung nach einem der vorstehenden Ansprüche, wobei die Auswertung durch die Verarbeitungseinheit (400) eine Auswertung des zeitlichen Verlaufs der ermittelten Messwerte umfasst.

7. Vorrichtung nach einem der vorstehenden Ansprüche, wobei die Verarbeitungseinheit (400) dazu ausgebildet ist, einen Kurzschluss zu erkennen, wenn wenigstens ein ermittelter Stromwert oder ein aus mehreren ermittelten Stromwerten abgeleiteter Wert eine vorgegebene Schwelle überschreitet und die ermittelten Stromwerte vorgegebene Plausibilitätsregeln einhalten.

8. Vorrichtung nach einem der vorstehenden Ansprüche, wobei eine einzuhaltende Plausibilitätsregel vorsieht, dass die von den Stromsensoren (201-203) ermittelten Stromwerte zu einem gegebenen Zeitpunkt nicht alle das gleiche Vorzeichen aufweisen.

9. Vorrichtung nach einem der vorstehenden Ansprüche, umfassend einen Steuerausgang (405) zum Bereitstellen eines Steuersignals bei Erkennen eines Kurzschlusses durch die Verarbeitungseinheit (400) umfasst.

10. Verfahren zur Kurzschlussüberwachung einer an ein Drehstromnetz angeschlossenen Drehstromlast (250), mit den Schritten:
- Ermitteln von Messwerten mittels mehrerer Stromsensoren (201-203), die jeweils im Strompfad (101-103) unterschiedlicher Phasen des Drehstromnetzes angeordnet sind und jeweils über Anschlussleitungen an zugeordnete Anschlüsse (401-404) einer Verarbeitungseinheit (400) angeschlossen sind, wobei wenigstens zwei der Anschlussleitungen, über welche die Stromsensoren (201-203) an die Verarbeitungseinheit (400) angeschlossen sind, miteinander über ein Koppelglied (305-307) verbunden sind,
- Auswerten der ermittelten Messwerte oder daraus abgeleiteter Werte durch die Verarbeitungseinheit (400), an welche die Stromsensoren (201-203) angeschlossen sind, zur Erkennung eines Kurzschlusses, wobei das Auswerten eine Plausibilitätsprüfung der ermittelten Messwerte umfasst, um zwischen einem Kurzschluss und einer Beeinflussung der ermittelten Messwerte durch eine elektrische und/oder elektromagnetische Störung zu unterscheiden.

11. Verfahren nach Anspruch 10, wobei das Ermitteln der Messwerte mittels dreier Stromsensoren (201-203), die jeweils im Strompfad (101-103) unterschiedlicher Phasen des Drehstromnetzes angeordnet sind und jeweils über Anschlussleitungen an zugeordnete Anschlüsse (401-404) der Verarbeitungseinheit (400) angeschlossen sind, erfolgt.

12. Verfahren nach einem der Ansprüche 10 oder 11, wobei die Anschlussleitungen, über welche die Stromsensoren (201-203) an die Verarbeitungseinheit (400) angeschlossen sind, jeweils paarweise miteinander über separate Koppelglieder (305-307) miteinander verbunden sind.

13. Verfahren nach einem der Ansprüche 10 bis 12, wobei die Koppelglieder (305-307) jeweils derart als Hochpass ausgebildet sind, dass die Anschlussleitungen für hochfrequente Signale im Wesentlichen kurzgeschlossen werden, auf den Anschlussleitungen übertragene Messsignale der Stromsensoren (201-203) durch die Koppelglieder (305-307) aber im Wesentlichen unbeeinflusst werden.

14. Verfahren nach einem der Ansprüche 10 bis 13, wobei das Ermitteln von Messwerten kontinuierlich oder in vorgegebenen Zeitabständen, insbesondere zyklisch, erfolgt.

15. Verfahren nach einem der Ansprüche 10 bis 14 wobei das Auswerten durch die Verarbeitungseinheit (400) eine Auswertung des zeitlichen Verlaufs der ermittelten Messwerte umfasst.

16. Verfahren nach einem der Ansprüche 10 bis 15, wobei durch die Verarbeitungseinheit (400) ein Kurzschluss erkannt wird, wenn wenigstens ein ermittelter Stromwert oder ein aus mehreren ermittelten Stromwerten abgeleiteter Wert eine vorgegebene Schwelle überschreitet und die ermittelten Stromwerte vorgegebene Plausibilitätsregeln einhalten.

17. Verfahren nach einem der Ansprüche 10 bis 16, wobei eine einzuhaltende Plausibilitätsregel vorsieht, dass die von den Stromsensoren (201-203) ermittelten Stromwerte zu einem gegebenen Zeitpunkt nicht alle das gleiche Vorzeichen aufweisen.

18. Verfahren nach einem der Ansprüche 10 bis 17, wobei bei Erkennen eines Kurzschlusses durch die Verarbeitungseinheit (400) ein Steuersignal erzeugt wird.

## Claims

1. An apparatus for short-circuit monitoring (100) of a three-phase load (250) connected to a three-phase supply, comprising:
- a plurality of current sensors (201 - 203), each one arranged in the current path (101 - 103) of different respective phases of the three-phase supply;
- a processing unit (400) for evaluating the measurement values of the current sensors (201 - 203), which has a respective port (401 - 404) for each current sensor (201 - 203) to which the respective current sensor (201 - 203) is connected via a connecting line; wherein the processing unit (400) is adapted to detect a short circuit on the three-phase load (250) through evaluation of the measurement values as determined by the current sensors (201 - 203), wherein said evaluation comprises a plausibility check of the determined measurement values for distinguishing between a short circuit and an influence on the determined measurement values by electrical and/or electromagnetic interference; and wherein at least two of the connecting lines connecting the current sensors (201 - 203) to the processing unit (400) are interconnected to each other via a coupling element (305 - 307).

2. The apparatus according to claim 1, comprising three current sensors (201 - 203), each of which is arranged in the current path (101 - 103) of a different phase of the three-phase supply and is connected to a respective associated port (401 - 404) of the processing unit (400) via a respective connecting line.

3. The apparatus according to any one of the preceding claims, wherein the connecting lines connecting the current sensors (201 - 203) to the processing unit (400) are interconnected to each other in pairs via separate coupling elements (305 - 307).

4. The apparatus according to any one of the preceding claims, wherein each of the coupling elements (305 - 307) is in the form of a high-pass such that the connecting lines are substantially short-circuited for high-frequency signals, while measurement signals of the current sensors (201 - 203) carried on the connecting lines remain substantially unaffected by the coupling elements (305 - 307).

5. The apparatus according to any one of the preceding claims, which, for the purpose of short-circuit monitoring, is adapted to determine current measurement values continuously or at predetermined time intervals, in particular cyclically, using the current sensors (201 - 203).

6. The apparatus according to any one of the preceding claims, wherein the evaluation by the processing unit (400) comprises an evaluation of the time profile of the determined measurement values.

7. The apparatus according to any one of the preceding claims, wherein the processing unit (400) is adapted to detect a short circuit when at least one determined current value or a value derived from a plurality of determined current values exceeds a predefined threshold and the determined current values meet predefined plausibility rules.

8. The apparatus according to any one of the preceding claims, wherein a plausibility rule to be met defines that the current values as determined by the current sensors (201 - 203) must not all have the same sign at a given point in time.

9. The apparatus according to any one of the preceding claims, comprising a control output (405) for providing a control signal upon detection of a short circuit by the processing unit (400).

10. A method for short-circuit monitoring of a three-phase load (250) connected to a three-phase supply, comprising the steps of:
- determining measurement values using a plurality of current sensors (201 - 203), each one arranged in the current path (101 - 103) of different respective phases of the three-phase supply and connected, via respective connecting lines, to respective associated ports (401 - 404) of a processing unit (400), wherein at least two of the connecting lines connecting the current sensors (201 - 203) to the processing unit (400) are interconnected to each other via a coupling element (305 - 307);
- evaluating the determined measurement values or values derived therefrom, by the processing unit (400) to which the current sensors (201 - 203) are connected, for detecting a short circuit, wherein said evaluating comprises a plausibility check of the determined measurement values in order to distinguish between a short circuit and an influence on the determined measurement values by electrical and/or electromagnetic interference.

11. The method as claimed in claim 10, wherein the determining of the measurement values is achieved using three current sensors (201 - 203), each of which is arranged in the current path (101 - 103) of a different phase of the three-phase supply and is connected to a respective associated port (401 - 404) of the processing unit (400) via a respective connecting line.

12. The method according to any one of claims 10 or 11, wherein the connecting lines connecting the current sensors (201 - 203) to the processing unit (400) are interconnected to each other in pairs via separate coupling elements (305 - 307).

13. The method according to any one of claims 10 to 12, wherein each of the coupling elements (305 - 307) is configured as a high-pass such that the connecting lines are substantially short-circuited for high-frequency signals, while measurement signals of the current sensors (201 - 203) carried on the connecting lines remain substantially unaffected by the coupling elements (305 - 307).

14. The method according to any one of claims 10 to 13, wherein the determining of measurement values is performed continuously or at predetermined time intervals, in particular cyclically.

15. The method according to any one of claims 10 to 14, wherein the evaluating by the processing unit (400) comprises evaluating the time profile of the determined measurement values.

16. The method according to any one of claims 10 to 15, wherein a short circuit is detected by the processing unit (400) when at least one determined current value or a value derived from a plurality of determined current values exceeds a predefined threshold and the determined current values meet predefined plausibility rules.

17. The method according to any one of claims 10 to 16, wherein a plausibility rule to be met defines that the current values determined by the current sensors (201 - 203) must not all have the same sign at a given point in time.

18. The method according to any one of claims 10 to 17, wherein upon detection of a short circuit by the processing unit (400), a control signal is generated.

## Revendications

1. Dispositif de surveillance de court-circuit (100) d'une charge de courant triphasé (250) raccordée à un réseau à courant triphasé, comprenant
- plusieurs capteurs de courant (201-203) qui sont respectivement agencés dans le trajet de courant (101-103) de différentes phases du réseau à courant triphasé,
- une unité de traitement (400) pour exploiter les valeurs mesurées des capteurs de courant (201-203) avec respectivement un raccordement (401-404) pour chaque capteur de courant (201-203) auquel est raccordé le capteur de courant (201-203) respectif via un câble de raccordement, où l'unité de traitement (400) est conçue pour reconnaître un court-circuit au niveau de la charge de courant triphasé (250) en exploitant des valeurs mesurées déterminées par les capteurs de courant (201-203), où l'exploitation comprend un contrôle de vraisemblance des valeurs mesurées déterminées pour faire une différence entre un court-circuit et une perturbation des valeurs mesurées déterminées par une perturbation électrique et/ou électromagnétique, et où au moins deux des câbles de raccordement, via lesquels les capteurs de courant (201-203) sont raccordés à l'unité de traitement (400), sont reliés ensemble via un organe d'accouplement.

2. Dispositif selon la revendication 1, comprenant trois capteurs de courant (201-203) qui sont respectivement agencés dans le trajet de courant (101-103) de différentes phases du réseau à courant triphasé et sont respectivement raccordés via des câbles de raccordement à des raccordements (401-404) attribués de l'unité de traitement (400) .

3. Dispositif selon l'une des revendications précédentes, dans lequel les câbles de raccordement via lesquels les capteurs de courant (201-203) sont raccordés à l'unité de traitement (400) sont respectivement reliés ensemble par paire via des organes d'accouplement (305-307) séparés.

4. Dispositif selon l'une des revendications précédentes, dans lequel les organes d'accouplement (305-307) sont respectivement conçus en tant que filtre passe-haut de sorte que les câbles de raccordement soient substantiellement court-circuités pour des signaux haute fréquence, alors que des signaux de mesure des capteurs de courant (201-203) transférés sur les câbles de raccordement ne sont substantiellement pas perturbés par les organes d'accouplement (305-307).

5. Dispositif selon l'une des revendications précédentes, conçu pour déterminer, en vue de la surveillance de court-circuit, en continu ou dans des intervalles de temps prédéfinis, en particulier cycliques, des valeurs mesurées de courant au moyen des capteurs de courant (201-203).

6. Dispositif selon l'une des revendications précédentes, dans lequel l'exploitation par l'unité de traitement (400) comprend une exploitation du déroulement dans le temps des valeurs mesurées déterminées.

7. Dispositif selon l'une des revendications précédentes, dans lequel l'unité de traitement (400) est conçue pour reconnaître un court-circuit lorsqu'au moins une valeur de courant déterminée ou une valeur déduite de plusieurs valeurs de courant déterminées dépasse un seuil prédéfini et les valeurs de courant déterminées satisfont des règles de vraisemblance prédéfinies.

8. Dispositif selon l'une des revendications précédentes, dans lequel une règle de vraisemblance à satisfaire prévoit que les valeurs de courant déterminées par les capteurs de courant (201-203) ne présentent pas toutes le même signe annonciateur à un instant donné.

9. Dispositif selon l'une des revendications précédentes, comprenant une sortie de commande (405) pour fournir un signal de commande dès lors qu'un court-circuit a été reconnu par l'unité de traitement (400).

10. Procédé de surveillance de court-circuit d'une charge de courant triphasé (250) raccordée à un réseau à courant triphasé, comprenant les étapes consistant à :
- déterminer des valeurs mesurées au moyen de plusieurs capteurs de courant (201-203) qui sont respectivement agencés dans le trajet de courant (101-103) de différentes phases du réseau à courant triphasé et sont respectivement raccordés via des câbles de raccordement à des raccordements (401-404) attribués d'une unité de traitement (400), où au moins deux des câbles de raccordement, via lesquels les capteurs de courant (201-203) sont raccordés à l'unité de traitement (400), sont reliés ensemble via un organe d'accouplement (305-307),
- exploiter les valeurs mesurées déterminées ou des valeurs qui en sont déduites par l'unité de traitement (400), à laquelle sont raccordés les capteurs de courant (201-203), pour reconnaître un court-circuit, où l'exploitation comprend un contrôle de vraisemblance des valeurs mesurées déterminées pour faire une différence entre un court-circuit et une perturbation des valeurs mesurées déterminées par une perturbation électrique et/ou électromagnétique.

11. Procédé selon la revendication 10, dans lequel la détermination des valeurs mesurées s'effectue au moyen de trois capteurs de courant (201-203), qui sont respectivement agencés dans le trajet de courant (101-103) de différentes phases du réseau à courant triphasé et sont respectivement raccordés via des câbles de raccordement à des raccordements (401-404) attribués de l'unité de traitement (400).

12. Procédé selon l'une des revendications 10 ou 11, dans lequel les câbles de raccordement via lesquels les capteurs de courant (201-203) sont raccordés à l'unité de traitement (400) sont respectivement reliés ensemble par paire via des organes d'accouplement (305-307) séparés.

13. Procédé selon l'une des revendications 10 à 12, dans lequel les organes d'accouplement (305-307) sont respectivement conçus en tant que filtre passe-haut de telle sorte que les câbles de raccordement soient substantiellement court-circuités pour des signaux haute fréquence, alors que des signaux de mesure des capteurs de courant (201-203) transférés sur les câbles de raccordement ne sont substantiellement pas perturbés par les organes d'accouplement (305-307).

14. Procédé selon l'une des revendications 10 à 13, dans lequel la détermination de valeurs mesurées s'effectue en continu ou dans des intervalles de temps prédéfinis, en particulier cycliques.

15. Procédé selon l'une des revendications 10 à 14, dans lequel l'exploitation par l'unité de traitement (400) comprend une exploitation du déroulement dans le temps des valeurs mesurées déterminées.

16. Procédé selon l'une des revendications 10 à 15, dans lequel un court-circuit est reconnu par l'unité de traitement (400) lorsqu'au moins une valeur de courant déterminée ou une valeur déduite de plusieurs valeurs de courant déterminées dépasse un seuil prédéfini et les valeurs de courant déterminées satisfont des règles de vraisemblance prédéfinies.

17. Procédé selon l'une des revendications 10 à 16, dans lequel une règle de vraisemblance à satisfaire prévoit que les valeurs de courant déterminées par les capteurs de courant (201-203) ne présentent pas toutes le même signe annonciateur à un instant donné.

18. Procédé selon l'une des revendications 10 à 17, dans lequel un signal de commande est produit dès lors qu'un court-circuit a été reconnu par l'unité de traitement (400) .
